(19) Europäisches Patentamt
European Patent Office
Office européen des brevets

(11) **EP 3 159 982 B1**

(12) **EUROPÄISCHE PATENTSCHRIFT**

(45) Veröffentlichungstag und Bekanntmachung des Hinweises auf die Patenterteilung:
**27.11.2019 Patentblatt 2019/48**

(51) Int Cl.:
***H01S 5/042*** *(2006.01)*     *H01S 5/062* *(2006.01)*

(21) Anmeldenummer: **16195067.0**

(22) Anmeldetag: **21.10.2016**

(54) **ERZEUGUNG VON LASER PULSEN MIT STABILER FORM**

GENERATION OF LASER PULSES WITH STABLE SHAPE

GÉNÉRATION D'IMPULSIONS LASER AVEC FORME STABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.10.2015 DE 102015118036**

(43) Veröffentlichungstag der Anmeldung:
**26.04.2017 Patentblatt 2017/17**

(73) Patentinhaber: **JENOPTIK Optical Systems GmbH 07745 Jena (DE)**

(72) Erfinder:
• **JÜNEMANN, Otto**
**07751 Bucha (DE)**
• **SCHALLER, Uwe**
**07768 Kahla (DE)**

(74) Vertreter: **Schaller, Renate et al Patentanwälte Oehmke & Kollegen Neugasse 13 07743 Jena (DE)**

(56) Entgegenhaltungen:
**DE-C5-102011 011 875     US-A- 3 651 341 US-A- 5 708 673**

**Beschreibung**

Bei der Laserimpuls-Laufzeitmessung wird die Laufzeit Δt zwischen einem Sendezeitpunkt eines Laserimpulses und einem Empfangszeitpunkt eines Refleximpulses in eine Distanz D gemäß $D = v_{licht} \cdot \Delta t/2$ gewandelt. Der Sendezeitpunkt und der Empfangszeitpunkt resultieren aus den Impulsformen des Laserimpulses und des Refleximpulses und werden mit Hilfe der Abtastmethode oder der Schwellwertmethode gewonnen. Die Impulsform ist beispielsweise charakterisierbar durch Anstiegs- und Abfallzeit, Impulsbreite und Impulshöhe. Dabei ist die Distanzmessgenauigkeit von der Stabilität der Impulsformen im Betriebstemperaturbereich des den Laserimpuls erzeugenden Laserimpulsgenerators abhängig.

Typisch ist die Erzeugung der Laserimpulse durch eine Laserdiode, die über eine Kondensatorentladung, kaskadiert über einen Avalanchetransistor, angesteuert wird. Dabei führen temperaturabhängige elektrische Parameter, insbesondere die elektrischen Widerstände des Avalanchetransistors und der Laserdiode, zu einer Veränderung der Impulsform des Laserimpulses und damit auch des Refleximpulses im Sub-Nanosekunden-Bereich. Diese Veränderungen führen zu Schwankungen der aus der Laufzeitmessung ermittelten Distanz innerhalb des Betriebstemperaturbereiches von bis zu einigen cm.

Darüber hinaus ist man bestrebt, den Rahmen einer dem Laserimpulsgenerator zugeordneten Laserklasse auszuschöpfen, das heißt die Energie der erzeugten Laserimpulse stets nur knapp unterhalb des zulässigen Grenzwertes zu halten, um eine maximale Rechweite zu erzielen. Im Laufe der Lebensdauer des Laserimpulsgenerators führt jedoch die Alterung der Bauelemente des Laserimpulsgenerators trotz konstanter Pumpspannung zu einer Verringerung der Energie der Laserimpulse und damit zu einer Verkürzung der Messweite.

Mit einem erfindungsgemäßen Laserimpulsgenerator soll sowohl die durch Temperaturschwankungen begründete Messtoleranz, aber vorteilhaft auch der Energieabfall der Laserimpulse über die Lebensdauer des Laserimpulsgenerators vermieden werden.

In der Patentschrift DE 10 2011 011 875 C5 wird eine Schaltungsanordnung zum Betrieb mehrerer Einzellaser beschrieben, bei der ein gemeinsamer Ladekondensator durch die Entladung einer gemeinsamen Induktivität vor der Auslösung eines Laserimpulses durch einen Einzellaser auf eine Spannung je nach Messentfernung und / oder Wirkungsgrad pro Einzellaser aufgeladen wird. Die für eine bestimmte Ladespannung benötigte Ladezeit der Induktivität wird gemessen und gespeichert.

Damit können unterschiedliche Wirkungsgrade der Einzellaser kompensiert werden.

In der Patentschrift DE 32 16 312 C2 ist eine Schaltungsanordnung zum Betrieb von Impulslaserdioden beschrieben, in der mittels Impulstransformator mit entsprechendem Wicklungsverhältnis ein Hochspannungsimpuls generiert wird, der einen Ladekondensator auflädt. Bei Erreichen einer vorgegebenen Spannung über dem Ladekondensator wird ein Transistor gezündet und der Ladekondensator entlädt sich mit einem kurzen Entladestromimpuls über die Laserdiode. Gleichzeitig wird der Ladeimpuls an der Primärseite des Impulstransformators beendet, so dass die Ladungszufuhr zum Speicherkondensator gestoppt wird.

Damit wird erreicht, dass vor jeder Entladung die gleiche Ladungsmenge im Ladekondensator gespeichert wird, so dass die Laserimpulsenergie jedes Laserimpulses einer Folge von Laserimpulsen vorgegeben ist, vorausgesetzt die Widerstände des Transistors und der Laserdiode sind stabil.

Bei den vorgenannten Laserimpulsgeneratoren für Halbleiter-Impulslaserdioden bleibt die Notwendigkeit eines über den Betriebstemperaturbereich und über die Lebensdauer des Laserimpulsgenerators formstabilen Laserimpulses unberücksichtigt. Die in den beschriebenen Entladekreisen enthaltenen Bauelemente, insbesondere die Halbleiter-Bauelemente, besitzen naturgemäß ein mehr oder weniger temperaturabhängiges Verhalten, das im Betriebstemperaturbereich zur Veränderung der Form des Laserimpulses führt. Wird eine derartige Schaltungsanordnung als Laserimpulsgenerator in einem Distanzsensor eingesetzt, der auf einer Impulslaufzeitmessung basiert, wird sich eine temperaturabhängige Impulsverformung ergeben, die zu einer für viele Anwendungsfälle ungenügenden Distanzmessgenauigkeit im Einsatztemperaturbereich und langzeitbetrachtet zu einer geringeren Messweite führt.

Es ist die Aufgabe der Erfindung, einen Laserimpulsgenerator zu finden, bei dem zur Erhöhung der Distanzmessgenauigkeit die Impulsform des Laserimpulses im Einsatztemperaturbereich stabilisiert wird. Die dazu notwendigen schaltungstechnischen und verfahrenstechnischen Mittel sollen kostengünstig und einfach sowohl in bereits konzipierte als auch in künftige Distanzsensoren, basierend auf der Impulslaufzeitmessung, integrierbar sein.

Die Aufgabe der Erfindung wird mit einem Laserimpulsgenerator gemäß Anspruch 1, enthaltend einen Monoimpulshochspannungsgenerator, mit einer Spannungsquelle, einem induktiven Bauelement und einem Schalter, und einen Impulsstromgenerator, mit einer ersten Diode, einem Pumpkondensator, einer zweiten Diode, einem Avalanchetransistor und einer Laserdiode, gelöst.

Bei geöffnetem Schalter bilden die erste Diode, der Pumpkondensator und die zweite Diode einen zweiten Ladekreis. Bei geschaltetem Avalanchetransistor bildet der Pumpkondensator mit dem Avalanchetransistor und der Laserdiode einen Entladekreis.

Der Laserimpulsgenerator enthält des Weiteren einen Impulsbreitengenerator, der an den Schalter Steuerimpulse liefert, mit einer Taktfrequenz und einer Steuerimpulsbreite, bestimmend für eine Schließzeit des Schalters und damit der Ladezeit des induktiven Bauelementes, und einen Verzögerungsgenerator, der den Avalanchetransistor nach einer Verzögerungszeit schaltet.

Es ist erfindungswesentlich, dass ein Temperatursensor vorhanden ist, der die Temperatur des Avalanchetransistors erfasst, und der Temperatursensor mit dem Impulsbreitengenerator verbunden ist, sodass dieser die Steuerimpulsbreite abhängig von einem vom Temperatursensor bereit gestellten Temperatursignal generiert.

Damit wird die temperaturabhängige Widerstandsänderung, die den Entladestromimpuls beeinflusst, welcher die Laserdiode anregt, kompensiert. Die erfasste Temperatur wird genutzt, um die Dauer der Aufladung des induktiven Bauelementes und damit die Höhe der bei Öffnung des Schalters erzeugten Ladespannung zu steuern, so dass eine damit einhergehende Veränderung der Form des Entladestromimpulses und folglich eine Veränderung der Pulsform des Laserimpulses, der für einen Distanzsensor einen Sendeimpuls darstellt, kompensiert werden.

Vorteilhaft ist der Temperatursensor mit dem Verzögerungsgenerator verbunden, sodass dieser die Verzögerungszeit abhängig von einem vom Temperatursensor bereit gestellten Temperatursignal generiert.

Nachfolgend soll die Erfindung an einem Ausführungsbeispiel anhand einer Zeichnung näher erläutert werden. Hierzu zeigt:

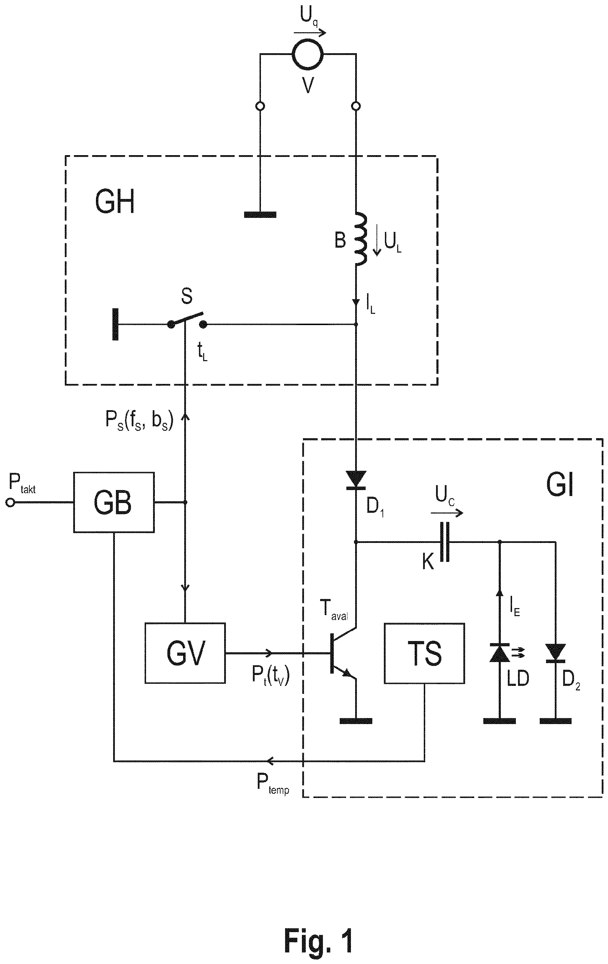

Fig. 1    eine Schaltungsanordnung eines erfindungsgemäßen Laserimpulsgenerators.

Ein erfindungsgemäßer Laserimpulsgenerator besteht gleich dem Stand der Technik aus einem Monoimpulshochspannungsgenerator GH, einem Impulsstromgenerator GI, einem Impulsbreitengenerator GB und einem Verzögerungsgenerator GV.

Darüber hinaus enthält ein erfindungsgemäßer Laserimpulsgenerator als erfindungswesentlich einen Temperatursensor TS, der mit dem Impulsbreitengenerator GB sowie vorteilhaft auch mit dem Verzögerungsgenerator GV signaltechnisch in Verbindung steht und eine Temperatur erfasst, die durch Wärmeleitung und Wärmestrahlung der Bauelemente des Entladestromkreises, der Bestandteil des Impulsstromgenerators GI ist, insbesondere des Avalanchetransistors $T_{aval}$, verursacht wird, deren Widerstände dominierend temperaturabhängig sind.

Der Monoimpulshochspannungsgenerator GH enthält grundsätzlich ein induktives Bauelement B und einen Schalter S und bildet verbunden mit einer Spannungsquelle V einen ersten Ladekreis, in dem, während der Schalter S in einer Ladezeit $t_L$ geschlossen ist, das induktive Bauelement B induktiv aufgeladen wird und mit dem Öffnen des Schalters S eine Ladespannung $U_L$ abgibt, die einer Monoimpulshochspannung entspricht.

Der Impulsstromgenerator GI enthält eine erste Diode $D_1$, einen Pumpkondensator K, eine zweite Diode $D_2$, einen Avalanchetransistor $T_{aval}$ und eine Laserdiode LD.

Gemeinsam mit dem induktiven Bauelement B bilden nach Öffnung des Schalters S die erste Diode $D_1$, der Pumpkondensator K und die zweite Diode $D_2$ einen zweiten Ladekreis. Während sich nach Öffnung des Schalters S das induktive Bauelement B entlädt, fließt ein Ladestromimpuls $I_L$ über die erste Diode D1, den Pumpkondensator K und die zweite Diode $D_2$ und der Pumpkondensator K wird auf die Pumpspannung $U_C$ aufgeladen. Die erste Diode $D_1$ verhindert das Zurückfließen der Ladung in das induktive Bauelement B. Die zweite Diode $D_2$ ist antiparallel zur Laserdiode LD geschaltet und ermöglicht sowohl das Aufladen des Pumpkondensators K als auch das Entladen des Pumpkondensators K nur über die Laserdiode LD.

Nachdem der Pumpkondensator K vollständig aufgeladen ist, wird an die Basis des Avalanchetransistors $T_{aval}$, die in Verbindung mit dem Verzögerungsgenerator GV steht, ein Zündimpuls $P_t$ angelegt, sodass der Avalanchetransistor $T_{aval}$ durchgeschaltet wird, das heißt er wird aus einem hochohmigen Zustand in einen niederohmigen Zustand geschaltet. In diesem Moment schließt sich der Entladekreis, gebildet durch den Pumpkondensator K, den Avalanchetransistor $T_{aval}$ und die Laserdiode LD. Der Pumpkondensator K entlädt sich über den niederohmig geschalteten Avalanchetransistor $T_{aval}$ und die Laserdiode LD. Der durch die Laserdiode LD fließende Entladestromimpuls $I_E$ regt die Laserstrahlung an, deren Impulsform mit dem zeitlichen Verlauf und damit der Impulsform des Entladestromimpulses $I_E$ nahezu übereinstimmt.

Bei der Entladung werden die Widerstände des Entladekreises wirksam, wobei für den zeitlichen Verlauf des Entladestromimpulses $I_E$ der niederohmige Widerstand des Avalanchetransistors $T_{aval}$ dominierend ist. Dieser ist mit ca. 10 Ohm gegenüber den anderen Widerständen des Entladekreises wesentlich größer, aber temperaturabhängig. So hat der niederohmige Widerstand einen Temperaturkoeffizienten von ca. -0,011 Ohm/K, so dass sich z. B. der niederohmige Widerstand im Temperaturbereich -20°C...+50°C um ca. 15 % ändert.

Bei Entladung einer unverändert hohen Pumpspannung Uc, gemäß dem Stand der Technik, unabhängig von dem sich temperaturabhängig ändernden Wert des niederohmigen Widerstandes, würde sich die Impulsform des Entladestromimpulses $I_E$ und damit die Form des Laserimpulses über den Einsatztemperaturbereich des Laserimpulsgenerators erheblich ändern.

Der erfindungsgemäß vorhandene Temperatursensor TS ist unmittelbar in der Umgebung des Avalanchetransistors $T_{aval}$ und bevorzugt auch der Laserdiode LD angeordnet, sodass er eine Temperatur erfasst, die durch Wärmestrahlung und Wärmeleitung wenigstens des Avalanchetransistors $T_{aval}$, bevorzugt aber beider Bauelemente beeinflusst wird. Es ist nicht von Wichtigkeit, die genaue tatsächliche Temperatur des Avalanchetransistors $T_{aval}$ bzw. der Laserdiode LD oder die Abhängigkeit der Widerstände der beiden Bauelemente von dessen Temperatur zu kennen. Zwar beeinflusst die Temperatur der beiden Bauelemente jeweils deren Widerstand im Einzelnen unterschiedlich, jedoch beeinflussen beide Widerstandsänderungen in Summe die Höhe des Entladestromimpulses $I_E$, weshalb eine durch beide Bauelemente bewirkte und gemessene Temperaturänderung einer Änderung einer Art Ersatzwiderstand zugeordnet werden kann.

Vor Inbetriebnahme des Laserimpulsgenerators werden über den Betriebstemperaturbereich, den Messtemperaturen zugeordnet, Ladezeiten $t_L$ ermittelt, die jeweils zu einer Aufladung des induktiven Bauelementes B auf eine Ladespannung $U_L$ erforderlich sind, welche die Widerstandsänderung der Widerstände des Entladekreises, insbesondere des Avalanchetransistors $T_{aval}$, kompensiert und die Impulsform des Entladestromimpulses $I_E$ und somit des Laserimpulses über den Betriebstemperaturbereich konstant hält.

Für eine noch bessere Stabilisierung des Laserimpulses können die ermittelten temperaturabhängigen Ladezeiten $t_L$ mit Hilfe von Erfahrungswerten einer Anpassung unterzogen werden, um gegebenenfalls temperaturabhängige Abweichungen der Laserimpulsform von der Form des Entladestromimpulses $I_E$ bzw. Langzeitveränderungen des Laserimpulses zu kompensieren.

Der Temperatursensor TS ist mit einem ersten Steuereingang des Impulsbreitengenerators GB verbunden, sodass hier kontinuierlich ein durch den Temperatursensor TS generiertes Temperatursignal $P_{temp}$ anliegt. An einem zweiten Steuereingang des Impulsbreitengenerators GB ist ein Taktsignal $P_{takt}$ mit einer vorgegebenen Taktfrequenz $f_s$ zur Erzeugung der Laserimpulsfrequenz angelegt. Der Ausgang des Impulsbreitengenerators GB ist mit dem Schalter S und dem Verzögerungsgenerator GV verbunden. An dem Schalter S und dem Verzögerungsgenerator GV liegen entsprechend durch den Impulsbreitengenerator GB generierte digitale Steuerimpulse $P_s$ mit der Taktfrequenz $f_s$ und mit einer Steuerimpulsbreite $b_s$ an, die für die Schließzeit des Schalters S bestimmend und damit gleich der Ladezeit $t_L$ des induktiven Bauelementes B ist. Während der Ladezeit $t_L$ ist der Schalter S geschlossen und das induktive Bauelement B wird durch den Ladestromimpuls $I_L$ aufgeladen. Mit dem Ende der Ladezeit $t_L$ wird der Schalter S geöffnet und das induktive Bauelement B überträgt in einer Energieübertragungszeit, die abhängig ist von der Höhe der übertragenen gespeicherten Energie $W_L$, seine gespeicherte Energie $W_L$ über die erste Diode $D_1$ auf den Pumpkondensator K, sodass die im induktiven Bauelement B gespeicherte Energie $W_L$ quasi vollständig zur Aufladung des Pumpkondensators K genutzt wird und dort als gespeicherte Energie $W_C$ über dem Pumpkondensator K anliegt.

Mit dem Ende der Ladezeit $t_L$ wird auch der Verzögerungsgenerator GV getriggert, der eine Verzögerungszeit $t_v$ erzeugt. Erst mit dem Ablauf der Verzögerungszeit $t_v$, und damit nach Abschluss der Übertragung der im induktiven Bauelement B gespeicherten Energie $W_L$, mit einer Energieübertragungszeit wird im Verzögerungsgenerator GV ein kurzer Zündimpuls $P_t$ erzeugt, der den Avalanchetransistor $T_{aval}$ durchschaltet.

Da die Ladezeit $t_L$ vom Temperatursignal $P_{temp}$ abhängig ist und der Verzögerungsgenerator GV am Ende der Ladezeit $t_L$ geschaltet wird, wird der Verzögerungsgenerator GV ebenfalls vom Temperatursignal $P_{temp}$ abhängig geschaltet. Aus dem Zeitpunkt des Schaltens des Verzögerungsgenerators GV und einer festen Verzögerungszeit $t_v$ ergibt sich der Zeitpunkt des Zündimpulses $P_t$.

Dabei wird eine Verzögerungszeit $t_v$ so gewählt, dass sie länger ist als die maximale, zur Ladezeit $t_L$ proportionale Energieübertragungszeit.

Um allerdings den Avalanchetransistor $T_{aval}$ möglichst unmittelbar nach Ende der Energieübertragungszeit zu schalten, kann der Temperatursensor TS auch direkt mit einem Eingang des Verzögerungsgenerators GV verbunden werden und die Verzögerungszeit $t_v$ ebenfalls in Abhängigkeit von dem Temperatursignal $P_{temp}$ gesteuert werden.

Mit dem Temperatursensor TS wird die Temperatur des Avalanchetransistors $T_{aval}$ kontinuierlich gemessen. Zur möglichst genauen Messung ist der Temperatursensor TS in unmittelbarer Nähe zum Avalanchetransistor $T_{aval}$, bevorzugt auf dem Avalanchtransistor $T_{aval}$ aufgeklebt angeordnet.

Durch die Nachführung der elektrischen Ladung $Q = C * U_C$ des Pumpkondensators K mittels einer in Abhängigkeit von der Temperatur proportional zur Schließzeit des Schalters S erzeugten Pumpspannung $U_C$ wird der Entladestromimpuls $I_E$ konstant gehalten, so dass der temperaturabhängige Einfluss des niederohmigen Widerstandes kompensiert wird.

Ausgehend von der nahezu vollständigen Übertragung der in dem induktiven Bauelement B gespeicherten Energie $W_L = L / 2 * I_L^2$ (wobei L die Induktivität des induktiven Bauelementes B ist) auf den Pumpkondensator K mit der gespeicherten Energie $W_C = C / 2 * U_C^2$ (wobei C die Kapazität der Pumpkondensators K ist) ergibt sich aus $W_L \approx W_C$ und aus $I_L = U_q * t_L / L$ (wobei $t_L$ die Ladezeit des induktiven Bauelementes B, $U_q$ die Vorspannung der Spannungsquelle V und $I_L$ der Ladestromimpuls ist).

$$U_C \approx U_q * t_L / (\sqrt{L} * \sqrt{C})$$

Da die Vorspannung $U_q$, die Induktivität L und die Kapazität C als konstant betrachtet werden können, ergibt sich die Pumpspannung Uc als eine proportionale Funktion der Ladezeit $t_L$

$$U_C = f(t_L)$$

mit dem Proportionalitätsfaktor

$$U_q/(\sqrt{L}*\sqrt{C}).$$

Hierbei wurden die Vorspannung $U_q$, die Induktivität L und die Kapazität C als konstant angenommen und die elektrischen Verluste außer Betracht gelassen.

Damit ist eine einfache, digitale Steuerbarkeit der Ladespannung $U_L$ und damit der Pumpspannung $U_C$ über die Ladezeit $t_L$ gegeben.

Zur Stabilisierung der Laserimpulsform wird erfindungsgemäß die Temperatur des Avalanchetransistors $T_{aval}$ gemessen und ein Temperatursignal $P_{temp}$ gewonnen, mit dem die Pumpspannung $U_C$ gesteuert wird.

Bezugszeichenliste

| | |
|---|---|
| GH | Monoimpulshochspannungsgenerator |
| GI | Impulsstromgenerator |
| GB | Impulsbreitengenerator |
| GV | Verzögerungsgenerator |
| V | Spannungsquelle |
| $U_q$ | Vorspannung |
| B | induktives Bauelement |
| $U_L$ | Ladespannung |
| $I_L$ | Ladestromimpuls |
| S | Schalter |
| $D_1$ | erste Diode |
| K | Pumpkondensator |
| $U_C$ | Pumpspannung |
| $D_2$ | zweite Diode |
| $T_{aval}$ | Avalanchetransistor |
| LD | Laserdiode |
| TS | Temperatursensor |
| $P_{temp}$ | Temperatursignal |
| $P_{takt}$ | Taktsignal |
| $t_L$ | Ladezeit (des induktiven Bauelementes B) |
| $f_s$ | Taktfrequenz |
| $t_v$ | Verzögerungszeit |
| $P_t$ | Zündimpuls |
| $I_E$ | Entladestromimpuls |
| $P_s$ | Steuerimpuls |
| $b_s$ | Steuerimpulsbreite |

**Patentansprüche**

1. Laserimpulsgenerator mit stabiler Pulsform von Laserimpulsen, enthaltend einen Monoimpulshochspannungsgenerator (GH), mit einer Spannungsquelle (V), einem induktiven Bauelement (B) und einem Schalter (S), einen Impulsstromgenerator (GI), mit einer ersten Diode ($D_1$), einem Pumpkondensator (K), einer zweiten Diode ($D_2$), einem Avalanchetransistor ($T_{aval}$) und einer Laserdiode (LD), wobei bei geöffnetem Schalter (S) die erste Diode ($D_1$), der Pumpkondensator (K) und die zweite Diode ($D_2$) einen zweiten Ladekreis bilden und bei geschaltetem Avalanchetransistor ($T_{aval}$) der Pumpkondensator (K) mit dem Avalanchetransistor ($T_{aval}$) und der Laserdiode (LD) einen Entladekreis bildet, einen Impulsbreitengenerator (GB), der an den Schalter (S) Steuerimpulse ($P_s$) liefert, mit einer Taktfrequenz ($f_s$) und einer Steuerimpulsbreite ($b_s$), bestimmend für eine Schließzeit des Schalters (S) und damit eine Ladezeit ($t_L$) des induktiven Bauelementes (B), und einen Verzögerungsgenerator (GV), der den Avalanchetransistor ($T_{aval}$) nach einer Verzögerungszeit ($t_v$) schaltet, **dadurch gekennzeichnet, dass** ein Temperatursensor (TS) vorhanden ist, der die Temperatur des Avalanchetransistors ($T_{aval}$) erfasst, und der Temperatursensor (TS) mit dem Impulsbreitengenerator (GB) verbunden ist, der so ausgelegt ist, dass dieser jeweils abhängig von einem vom Temperatursensor (TS) bereitgestellten Temperatursignal ($P_{temp}$) die Steuerimpulsbreite ($b_s$) generiert, die jeweils für die Ladezeit ($t_L$) des induktiven Bauelementes (B) auf eine Ladespannung ($U_L$) erforderlich ist, um Veränderungen der Pulsform der Laserimpulse zu kompensieren.

2. Laserimpulsgenerator mit stabiler Pulsform von Laserimpulsen nach Anspruch 1, **dadurch gekennzeichnet, dass** der Temperatursensor (TS) mit dem Verzögerungsgenerator (GV) verbunden ist, sodass dieser die Verzögerungszeit ($t_v$) abhängig von dem vom Temperatursensor (TS) bereitgestellten Temperatursignal ($P_{temp}$) generiert.

**Claims**

1. Laser pulse generator with stable pulse shape of laser pulses, containing a mono pulse high voltage generator (GH) having a voltage source (V), an inductive component (B) and a switch (S), a pulse current generator (GI) having a first diode ($D_1$), a pumping capacitor (K), a second diode ($D_2$), an avalanche transistor ($T_{aval}$) and a laser diode (LD), wherein, when the switch (S) is open, the first diode ($D_1$), the pumping capacitor (K) and the second diode ($D_2$) form a second charging circuit and, when the avalanche transistor ($T_{aval}$) is switched, the pumping capacitor (K) forms a discharge circuit with the avalanche transistor ($T_{aval}$) and the laser diode (LD), a pulse width generator (GB) which provides control pulses ($P_s$) to the switch (S) with a pulse frequency ($f_s$) and a control pulse width ($b_s$) determining a closing time of the switch (S) and thus a charging time

($t_L$) of the inductive component (B), and a delay generator (GV) switching the avalanche transistor ($T_{aval}$) after a delay time ($t_v$), **characterized in that** a temperature sensor (TS) is present which detects the temperature of the avalanche transistor ($T_{aval}$) and the temperature sensor (TS) is connected to the pulse width generator (GB) which is configured in such a way that it generates the control pulse width ($b_s$) depending on a temperature signal ($P_{temp}$) respectively provided by the temperature sensor (TS), which control pulse width ($b_s$) is required for the charging time ($t_L$) of the inductive component (B) to a charging voltage ($U_L$) in each instance in order to compensate changes in the pulse shape of the laser pulses.

2. Laser pulse generator with stable pulse shape of laser pulses according to claim 1, **characterized in that** the temperature sensor (TS) is connected to the delay generator (GV) so that the latter generates the delay time ($t_v$) depending on the temperature signal ($P_{temp}$) provided by the temperature sensor (TS).

**Revendications**

1. Générateur d'impulsions laser à forme d'impulsions stable d'impulsions laser, contenant un générateur de haute tension monopulse (GH) ayant une source de tension (V), un composant inductif (B) et un commutateur (S), un générateur de courant à impulsions (GI) ayant une première diode ($D_1$), un condensateur de pompage (K), une deuxième diode ($D_2$), un transistor à avalanche ($T_{aval}$) et une diode laser (LD), dans lequel, lorsque le commutateur (S) est ouvert, la première diode ($D_1$), le condensateur de pompage (K) et la deuxième diode ($D_2$) forment un deuxième circuit de charge et, lorsque le transistor à avalanche ($T_{aval}$) est commuté, le condensateur de pompage (K) forme un circuit de décharge avec le transistor à avalanche ($T_{aval}$) et la diode laser (LD), un générateur de largeur d'impulsions (GB) qui fournit au commutateur (S) des impulsions de commande ($P_s$) avec une fréquence d'impulsions ($f_s$) et une largeur d'impulsion de commande ($b_s$) déterminant un temps de fermeture du commutateur (S) et donc un temps de charge ($t_L$) du composant inductif (B), et un générateur de retard (GV) commutant le transistor à avalanche ($T_{aval}$) après un temps de retard ($t_v$), **caractérisé en ce qu'**un capteur de température (TS) est présent qui détecte la température du transistor à avalanche ($T_{aval}$) et le capteur de température (TS) est lié au générateur de largeur d'impulsions (GB) qui est configuré de sorte que ceci génère la largeur d'impulsion de commande ($b_s$) en fonction d'un signal de température ($P_{temp}$) fourni respectivement par le capteur de température (TS), la largeur d'impulsion de commande ($b_s$) étant nécessaire pour le temps de charge ($t_L$) du composant inductif (B) à une tension de charge ($U_L$) à chaque fois pour compenser des changements de la forme d'impulsions des impulsions laser.

2. Générateur d'impulsions laser à forme d'impulsions stable d'impulsions laser selon la revendication 1, **caractérisé en ce que** le capteur de température (TS) est lié au générateur de retard (GV) de sorte que ceci génère le temps de retard ($t_v$) en fonction du signal de température ($P_{temp}$) fourni par le capteur de température (TS).

**Fig. 1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011011875 C5
- DE 3216312 C2